# EUROPEAN PATENT APPLICATION

(11) **EP 4 700 582 A1**
(43) Date of publication of application: **25.02.2026**
(21) Application number: 25193801.5
(22) Date of filing: 04.08.2025
(51) Int. Cl.: G06F 11/10

(54) **CXL MEMORY CONTROLLER, OPERATING METHOD THEREFOR, AND CXL MEMORY DEVICE**

(30) Priority: 22.08.2024 KR 20240113100
(71) Applicant: Samsung Electronics Co., Ltd., Suwon-si, Gyeonggi-do 16677 (KR)
(72) Inventor: LEE, Kijun, 16677 Suwon-si (KR); LEE, Myungkyu, 16677 Suwon-si (KR); PARK, Sungjoo, 16677 Suwon-si (KR); SOHN, Kyomin, 16677 Suwon-si (KR)
(74) Representative: Marks & Clerk LLP

(57) **Abstract**

A compute expression link (CXL) memory controller includes a data conversion device that receives a fail bit map and converts the fail bit map into error correction code (ECC) predecoded information in a symbol unit, a read only memory (ROM) that stores the ECC predecoded information, and an ECC engine that performs a decoding operation based on the ECC predecoded information. The ECC predecoded information includes address information indicating an address in which an error occurs, error symbol position information indicating one or more symbols in which the error occurs from among symbols corresponding to the address, and error type information indicating an error type of the one or more symbols.

## Description

### BACKGROUND

Apparatuses, devices, and methods consistent with the present disclosure related to a compute express link (CXL) memory controller, and in particular, to a CXL memory controller including a data conversion device for converting a fail bit map (otherwise known as a "fail bitmap"), a method of operating the same, and a CXL memory device.

An apparatus configured to process data may carry out various operations by accessing a memory. For example, an apparatus may process data read from a memory or write processed data in a memory. Due to the performance and functions required for a system, various devices communicating with one another via a link that provides high bandwidth and low latency may be included in the system. A memory included in a system may be shared and accessed by two or more devices. Accordingly, the performance of a system may depend upon a communication efficiency among devices and the time taken to access the memory, as well as the operating speed of each apparatus.

### SUMMARY

It is an aspect to provide a compute express link (CXL) memory controller including a data conversion device capable of converting a fail bit map in the unit of an error correction code (ECC) or a symbol, a method of operating the same, and a CXL memory device.

According to an aspect of one or more embodiments, there is provided a compute expression link (CXL) memory controller comprising a data conversion device that receives a fail bit map and converts the fail bit map into error correction code (ECC) predecoded information in a symbol unit; a read only memory (ROM) that stores the ECC predecoded information; and an ECC engine that performs a decoding operation based on the ECC predecoded information. The ECC predecoded information includes address information indicating an address in which an error occurs, error symbol position information indicating at least one symbol in which the error occurs from among a plurality of symbols corresponding to the address, and error type information indicating an error type of the at least one symbol.

According to another aspect of one or more embodiments, there is provided an operating method of a compute express link (CXL) memory controller, the operating method comprising receiving a fail bit map; converting the fail bit map into error correction code (ECC) predecoded information in a symbol unit; storing the ECC predecoded information in a read only memory (ROM); and performing a decoding operation based on the ECC predecoded information. The ECC predecoded information includes address information indicating an address in which an error occurs, error symbol position information indicating at least one symbol in which the error occurs from among a plurality of symbols corresponding to the address, and error type information indicating an error type of the at least one symbol.

According to yet another aspect of one or more embodiments, there is provided a compute express link (CXL) memory device comprising a CXL memory including a first chip and a second chip; and a CXL memory controller including a data conversion device that receives a fail bit map including error information of each of the first chip and the second chip, and converts the fail bit map into error correction code (ECC) predecoded information in a symbol unit, a read only memory (ROM) that stores the ECC predecoded information, and a CXL memory controller including an ECC engine that receives an access request and performs ECC decoding based on the ECC predecoded information when a target address of the access request corresponds to address information. The ECC predecoded information comprises the address information indicating an address in which an error occurs, error symbol position information indicating at least one symbol in which the error occurs from among a plurality of symbols corresponding to the address, and error type information indicating an error type of the at least one symbol.

At least some of the above and other features of the invention are set out in the claims.

### BRIEF DESCRIPTION OF THE DRAWINGS

Various embodiments will be more clearly understood from the following detailed description taken in conjunction with the accompanying drawings in which:
FIG. 1A is a diagram showing an example of an electrical die sorting (EDS) device;
FIG. 1B is a diagram showing an example of a fail bit map;
FIG. 1C is a block diagram of a memory system;
FIG. 2A is a diagram showing an example of a data conversion device according to an embodiment;
FIG. 2B is a diagram showing an example of an error correction code (ECC) predecoded information, according to an embodiment;
FIG. 3 is a block diagram of a computing system including a storage system according to an embodiment;
FIG. 4 is a block diagram showing elements in the computing system according to an embodiment;
FIG. 5 is a diagram showing an example of a compute express link (CXL) memory controller according to an embodiment;
FIG. 6 is a diagram showing an example of ECC predecoded information stored in read-only memory (ROM) of the CXL memory controller, according to an embodiment;
FIG. 7 is a flowchart illustrating an operating method of a data conversion device according to an embodiment;
FIG. 8 is a block diagram of a computing system according to an embodiment;
FIG. 9 is a block diagram of a computing system according to an embodiment;
FIG. 10 is a block diagram of a computing system according to an embodiment; and
FIG. 11 is a block diagram of a data center according to an embodiment.

### DETAILED DESCRIPTION

Hereinafter, various embodiments will be described in detail with reference to accompanying drawings. In the description that follows, although terms such as "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a "first" element, component, region, layer or section described below could be termed a "second" element, component, region, layer or section, without departing from the scope of the present disclosure.

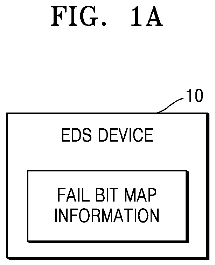

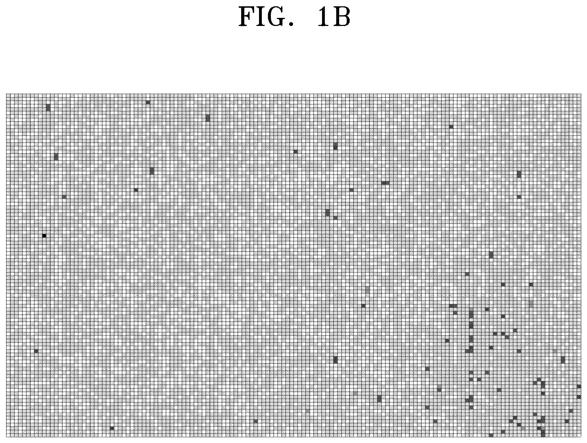

FIG. 1A is a diagram showing an example of an electrical die sorting (EDS) device, and FIG. 1B is a diagram showing an example of a fail bit map.

Referring to FIG. 1A, an EDS device 10 may perform an EDS test. The EDS test may include at least one test for selecting defective chips from among a plurality of chips on a wafer. For example, the EDS test may include an electrical test (ET) in which parameters of electrical direct current (DC) voltage and current characteristics are tested on individual devices (for example, transistors, resistors, capacitors, diodes, and the like), that are used in the operation of a chip, and accordingly, determine whether the individual devices are operable, a wafer burn in (WBI) test in which a predetermined temperature may be applied to a wafer, and then an alternating current (AC) voltage and a DC voltage may be applied thereto to detect defective chips, a pre-laser hot (PLH) test and a pre-laser cold (PLC) test for determining whether the individual devices normally operate at a high and low temperature before performing a laser repair using a fuse, a laser repair connecting repairable chips to a column or a row having the remaining cells, etc.

The EDS device 10 may generate a fail bit map and store the fail bit map as fail bit map information. Referring to FIG. 1B, the fail bit map may be information indicating how many fail bits exist in each of a plurality of chips on a wafer. For example, referring to FIG. 1B, the EDS device 10 may determine a grade according to the number of fail bits detected from each chip, and may generate the fail bit map indicating the grade of each chip. The EDS device 10 may determine to discard at least one chip including a certain grade of fail bits or greater, even after the laser repair. That is, the EDS device 10 may improve the yield by performing the repair after detecting defective chips in advance and improve the reliability of a product, but may be irrelevant with utilization of defective chips including the fail bits.

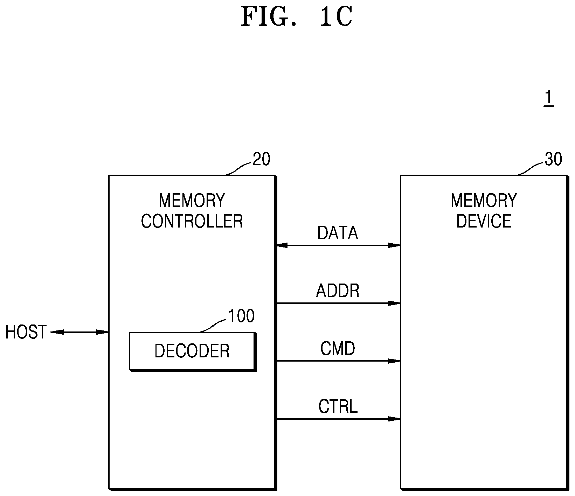

FIG. 1C is a block diagram of a memory system 1.

Referring to FIG. 1C, the memory system 1 may include a memory controller 20 and a memory device 30. The memory system 1 may be referred to as a storage device. In some embodiments, the memory system 1 may refer to an integrated circuit, an electronic device or system, a smartphone, a tablet personal computer (PC), a computer, a server, a workstation, a portable communication terminal, a personal digital assistant (PDA), a portable multimedia player (PMP), a computing device such as other suitable computers, a virtual machine or virtual computing device thereof, or the like. In some embodiments, the memory system 1 may include some of components in a computing system such as a graphics card. According to some embodiments, the memory system 1 may be implemented as an unbuffered dual in-line memory module (UDIMM), a registered DIMM (RDIMM), a load reduced DIMM (LRDIMM), a fully buffered DIMM (FBDIMM), a small outline DIMM (SODIMM), etc.

The memory device 30 may include a memory cell array including a plurality of memory cells. The memory cell array may include a plurality of word lines and a plurality of bit lines, and a plurality of memory cells formed on cross-points between the word lines and the bit lines. The memory cell of the memory cell array may include a volatile memory cell (e.g., a dynamic random access memory (DRAM) cell, a static RAM (SRAM) cell, etc.), a non-volatile memory cell (e.g., a flash memory cell, a resistive RAM (ReRAM) cell, a phase change RAM (PRAM) cell, a magnetic RAM (MRAM) cell), or another kind of memory cell.

In some embodiments, the memory system 1 may be implemented as a memory that is built in or detachably attached to an electronic device, e.g., the memory system 1 may be implemented in various types, such as an Embedded Universal Flash Storage (UPS) memory device, an embedded Multi-Media Card (eMMC), a Solid State Drive (SSD), a UFS memory card, a Compact Flash (CF) memory card, a Secure Digital (SD) memory card, a Micro Secure Digital (Micro-SD) memory card, a Mini Secure Digital (Mini-SD) memory card, an extreme Digital (xD) memory card, or a Memory Stick.

The memory controller 20 may read data stored in the memory device 30 in response to a write/read request from a host HOST, or control the memory device 30 to write data in the memory device 30. In detail, the memory controller 20 may provide the memory device 30 with an address ADDR, a command CMD, and a control signal CTRL, and control writing, reading, and erasing operations on the memory device 30. The data DATA to be stored in the memory device 30 and data DATA read from the memory device 30 may be transmitted between the memory controller 20 and the memory device 30.

The memory controller 20 may include a decoder 100. The decoder 100 may perform decoding using an error correction code (ECC) on the data read from the memory device 30. The decoder 100 performs the decoding and corrects the error in the read data. That is, the decoder 100 may correct the data read from the memory cell array of the memory device 30.

According to an embodiment, the decoder 100 may perform a post package repair (PPR) when detecting a fail bit exceeding an ECC performance during the runtime. For example, when a column or row including a redundant cell remains in the chip from which the fail bit is detected, the decoder 100 may disconnect from the cell in which the fail bit occurs and connect to the redundant cell to perform the repair. A redundant cell may be an additional (e.g. unused) cell that is held back for use in repairing (e.g. replacing) a failed cell.

According to an embodiment, the decoder 100 may enter a decoding mode in which the corresponding chip is not used. For example, when the number of fail bits exceeding the ECC performance is detected from a certain chip, the decoder 100 may determine not to use the corresponding chip. That is, when the chip out of the ECC performance range is detected, the decoder 100 simply does not use the corresponding chip to maintain the data reliability, but the determination not to use the corresponding chip is irrelevant with the utilization of defective chips including the fail bits.

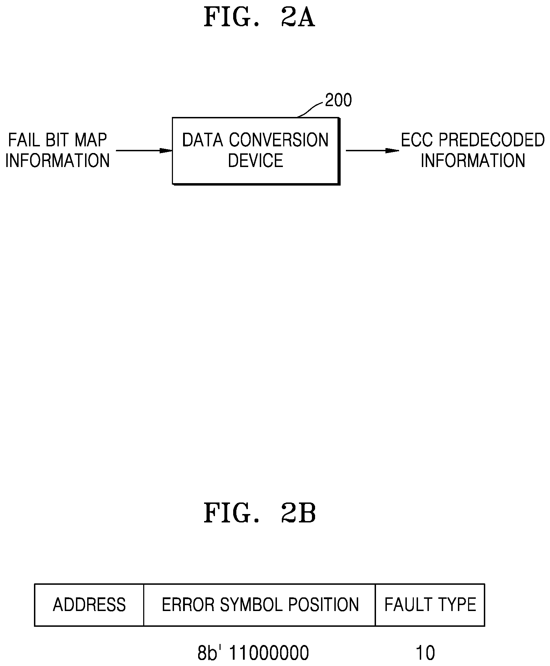

FIG. 2A is a diagram showing an example of a data conversion device 200 according to an embodiment, and FIG. 2B is a diagram showing an example of ECC predecoded information, according to an embodiment.

Referring to FIG. 2A, the data conversion device 200 may receive a fail bit map and convert the fail bit map to ECC predecoded information. The fail bit map may correspond to the fail bit map described above with reference to FIG. 1A. According to an embodiment, the fail bit map may have various units. For example, in some embodiments, the fail bit map may be in a single bit unit, may be in an 8-bit unit for repair, or may be in an address unit, a column unit, or a row unit. Each bit in the fail bit map may correspond to one or more storage units (e.g. one or more memory cells). Each bit in the fail bit map may correspond to a single storage unit (e.g. one memory cell), a number (e.g. eight) of storage units (e.g. eight memory cells), an address, a row (e.g. a row of memory cells), or a column (e.g. a column of memory cells).

The ECC predecoded information may include information for ECC decoding performed by an ECC engine. In detail, the ECC predecoded information may include address information, error symbol position information, and/or error type information.

The ECC engine may be based on Reed-Solomon code. A code word of the Reed-Solomon code may be decoded based on a position of a symbol where an error occurs, and an error value. Therefore, the data conversion device 200 may convert a received fail bit map to information as to an error symbol position for each address, which is used for decoding the Reed-Solomon code. That is, the data conversion device 200 may convert the fail bit map in an ECC processing unit or a symbol unit. Here, the information as to an error symbol position may be a set of a number of bits. In an embodiment, the number of bits may be a predefined number. For example, each of the bits may indicate which symbol of a certain address has an error that occurred. As an example, a bit may be assigned for each symbol of the address. The bit may be set to logic high (e.g. "1") if the corresponding symbol is identified as having an error (or having a number of errors greater than or equal to a threshold). The bit may be set to logic low (e.g. "0") if the corresponding symbol is identified as not having an error (or having less than a threshold number of errors). The order of the bits in the error symbol position information may be the same as the order of the symbols in the address.

In an embodiment, the ECC predecoded information may further include information about error type. For example, the error type may correspond to one of a first error type in which a single symbol has a defect with respect to a certain address, a second error type in which a certain row has a defect with respect to a certain address, and a third error type in which a certain column has a defect with respect to a certain address.

In an embodiment, a value of the first error type in which the error occurs in only one of the symbols of a certain address may be "01". Here, bits in the error symbol position information may indicate symbols where the error occurs from among the symbols of a certain address. For example, when the bits of the error symbol position information is "10000000", it may be identified that the error occurs in a first symbol from among the symbols of the certain address.

As illustrated in FIG. 2B, a value of the second error type in which the error occurs in at least two symbols from among the symbols of a certain address and the at least two symbols correspond to the same row may be "10". Here, bits in the error symbol position information may indicate symbols where the error occurs from among the symbols of a certain address. For example, in the case of error symbol position information of "11000000", it may denote that the error occurs in first and second symbols.

A value of the third error type in which the error occurs in at least two symbols from among the symbols of a certain address and the at least two symbols correspond to the same column may be "11". Here, bits in the error symbol position information may indicate symbols where the error occurs from among the symbols of a certain address. For example, in the case of error symbol position information of "10001000", it may denote that the error occurs in first and fifth symbols. The ECC engine based on the Reed-Solomon code may improve the error correction performance only by identifying the position of the symbol in which the error occurs with respect to a certain address.

While specific examples of values for the first, second and third error types are given, it will be appreciated that these are merely examples, and other values may be allocated to these error types.

According to an embodiment, the data conversion device 200 may be implemented in the EDS device 10 of FIG. 1A. When the data conversion device 200 is implemented in the EDS device 10, the EDS device 10 may include a communication circuit for uploading the ECC predecoded information onto a server (not shown).

According to an embodiment, the data conversion device 200 may be implemented in a memory controller (not shown). For example, in an embodiment, the data conversion device 200 may be implemented in a CXL controller included in the CXL memory device.

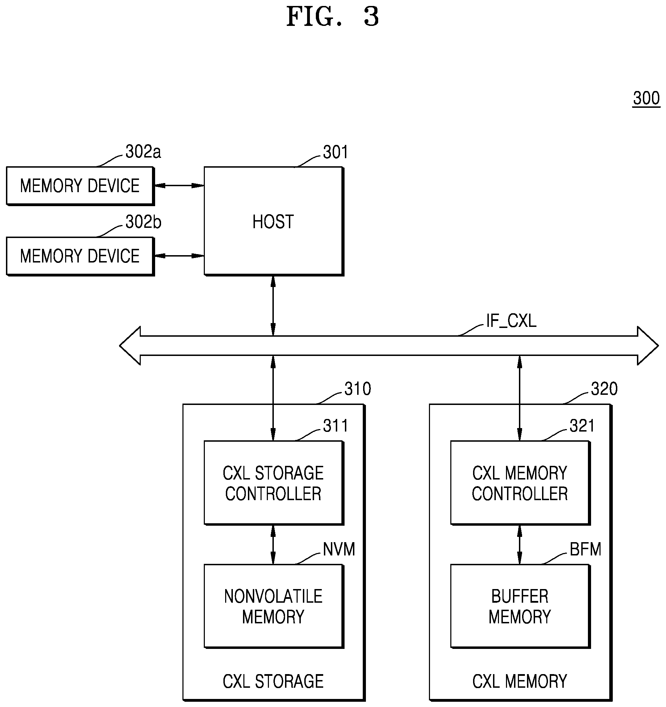

FIG. 3 is a block diagram of a computing system 300 including a storage system according to an embodiment.

Referring to FIG. 3, the computing system 300 may include a host 301, a plurality of memory devices 302a and 302b, a compute express link CXL storage 310, and a CXL memory 320.

In some embodiments, the computing system 300 may be included in a user device such as a PC, a laptop computer, a server, a media player, a digital camera, etc., or an automotive device such as a navigation, a block box, a vehicle electronic device, etc. In some embodiments, the computing system 300 may include a mobile system such as a mobile phone, a smart phone, a tablet PC, a wearable device, a health care device, and/or an Internet of Things (IoT) device.

The host 301 may control overall operations of the computing system 300. In some embodiments, the host 301 may be one of various processors such as a central processing unit (CPU), a graphics processing unit (GPU), a neural processing unit (NPU), a data processing unit (DPU), etc. In some embodiments, the host 301 may include a single-core processor or a multi-core processor.

The plurality of memory devices 302a and 302b may be used as a main memory or a system memory in the computing system 300. In some embodiments, the plurality of memory devices 302a and 302b may each include DRAM device, and may have a form factor of a dual in-line memory module (DIMM). However, embodiments are not limited thereto, and in some embodiments, the plurality of memory devices 302a and 302b may include a non-volatile memory such a flash memory, PRAM, RRAM, MRAM, etc.

The plurality of memory devices 302a and 302b may directly communicate with the host 301 via a double data rate (DDR) interface. In an embodiment, the host 301 may include a memory controller configured to control the plurality of memory devices 302a and 302b. However, embodiments are not limited thereto, and in some embodiments, the plurality of memory devices 302a and 302b may communicate with the host 302 via various interfaces.

The CXL storage 310 may include a CXL storage controller 311 and a non-volatile memory NVM. The CXL storage controller 311 may store data in the non-volatile memory NVM or transfer the data stored in the non-volatile memory NVM to the host 301, according to the control from the host 301. In an embodiment, the non-volatile memory NVM may be a NAND flash memory, but embodiments are not limited thereto.

The CXL memory 320 may include a CXL memory controller 321 and a buffer memory BFM. The CXL memory controller 321 may store data in the buffer memory BFM or transfer data stored in the buffer memory BFM to the host 301, according to the control from the host 301. In an embodiment, the buffer memory BFM may include DRAM, but embodiments are not limited thereto.

In an embodiment, the host 301, the CXL storage 310, and the CXL memory 320 may be configured to share the same interface with one another. For example, the host 301, the CXL storage 310, and the CXL memory 320 may communicate with one another via a CXL interface IF_CXL. In an embodiment, the CXL interface IF_CXL may denote a low-latency and high-bandwidth link enabling various connections among accelerators, memory devices, or various electronic devices by supporting coherency, memory access, and dynamic protocol multiplexing of an input/output protocol. The CXL interface IF_CXL may be an interface according to the CXL standard (e.g. an interface that complies with CXL 3.1, or an earlier or later version of the CXL standard). The CXL memory 320 may be a memory device that is able to communicate (e.g. transmit and receive data) according to the CXL standard. The CXL storage 310 may be a storage device that is able to communicate (e.g. transmit and receive data) according to the CXL standard.

In an embodiment, the CXL storage controller 311 may manage data stored in the non-volatile memory NVM by using map data. The map data may include information about a relationship between a logic block address managed by the host 301 and a physical block address of the non-volatile memory NVM.

In an embodiment, the CXL storage 310 may not include an additional buffer memory for storing or managing map data. In this case, a buffer memory for storing or managing the map data may be used. In an embodiment, at least some region of the CXL memory 320 may be used as a buffer memory of the CXL storage 310. In this case, a mapping table managed by the CXL storage controller 311 of the CXL storage 310 may be stored in the CXL memory 320. For example, at least some region of the CXL memory 320 may be allocated as a buffer memory (exclusive region for the CXL storage 310) of the CXL storage 310 by the host 301.

In an embodiment, the CXL storage 310 may access the CXL memory 320 via the CXL interface IF_CXL. For example, the CXL storage 310 may store the mapping table in or read the mapping stable from the allocated region in the CXL memory 320. The CXL memory 320 may store data (e.g., map data) in the buffer memory BFM or transfer data (e.g., map data) stored in the buffer memory BFM to the CXL storage 310, according to the control from the CXL storage 310.

The CXL storage controller 311 of the CXL storage 310 may communicate with the host 301 and the CXL memory (that is, the buffer memory) via the CXL interface IF_CXL. In other words, the CXL storage controller 311 of the CXL storage 310 may communicate with the host 301 and the CXL memory 320 via the same kind of interface or a common interface, and may use some region of the CXL memory 320 as a buffer memory.

Hereinafter, for convenience of description, it is assumed that the host 301, the CXL storage 310, and the CXL memory 320 communicate with one another via the CXL interface IF _CXL. However, embodiments are not limited thereto, and in some embodiments, the host 301, the CXL storage 310, and the CXL memory 320 may communicate with one another based on various computing interfaces such as GEB-Z protocol, NVLink protocol, cache coherent interconnect for accelerators (CCIX) protocol, open coherent accelerator processor interface (CAPI) protocol, etc.

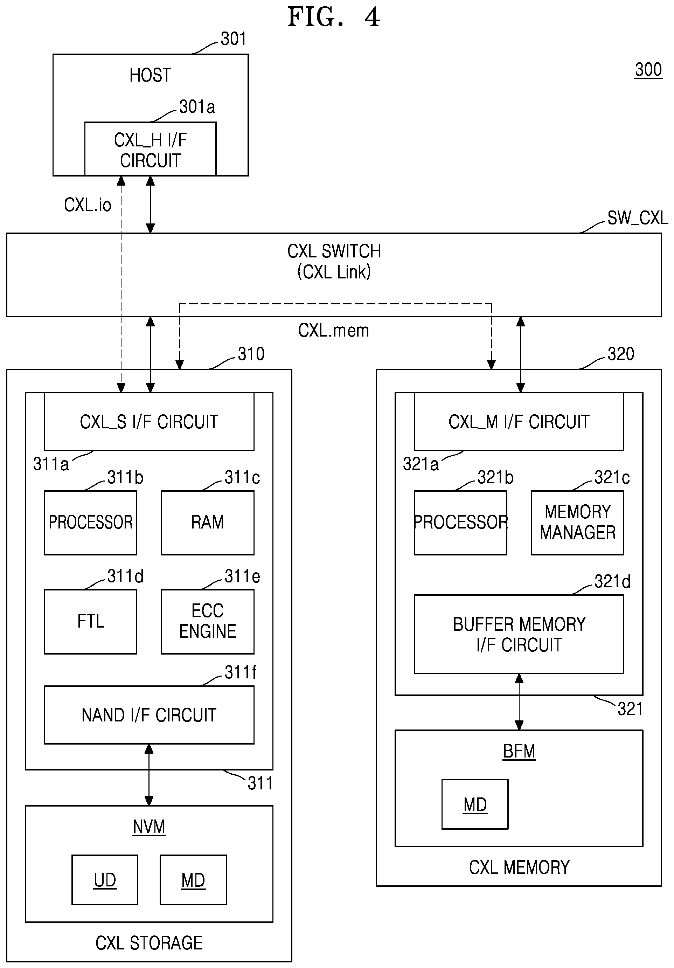

FIG. 4 is a block diagram showing elements in the computing system 300 according to an embodiment. In detail, FIG. 4 is a block diagram showing in detail elements of the computing system 300 of FIG. 3. FIG. 4 may be described with reference to FIG. 3, and redundant descriptions may be omitted for conciseness.

Referring to FIG. 4, the computing system 300 may include a CXL switch SW_CXL, the host 301, the CXL storage 310, and the CXL memory 320.

The CXL switch SW_CXL may be included in the CXL interface IF_CXL. The CXL switch SW_CXL may be configured to relay the communication among the host 301, the CXL storage 310, and the CXL memory 320. For example, when the host 301 and the CXL storage 310 communicate with each other, the CXL switch SW_CXL may be configured to transfer information such as a request, data, response, or signals transferred from the host 301 or the CXL storage 310 to the CXL storage 310 or the host 301. When the host 301 and the CXL memory 320 communicate with each other, the CXL switch SW_CXL may be configured to transfer information such as a request, data, response, or a signal transferred from the host 301 or the CXL memory 320 to the CXL memory 320 or the host 301. When the CXL storage 310 and the CXL memory 320 communicate with each other, the CXL switch SW_CXL may be configured to transfer information such as a request, data, response, or a signal transferred from the CXL storage 310 or the CXL memory 320 to the CXL memory 320 or the CXL storage 310. The host 301 may include a CXL host interface circuit 301a. The CXL host interface circuit 301a may communicate with the CXL storage 310 or the CXL memory 320 via the CXL switch SW_CXL.

The CXL storage 310 may include the CXL storage controller 311 and the non-volatile memory NVM. The CXL storage controller 311 may include a CXL storage interface circuit 311a, a processor 311b, a RAM 311c, a flash translation layer (FTL) 311d, an error correction code (ECC) engine 311e, and a NAND interface circuit 311f.

The CXL storage interface circuit 311a may be connected to the CXL switch SW_CXL. The CXL storage interface circuit 311a may communicate with the host 301 or the CXL memory 320 via the CXL switch SW_CXL.

The processor 311b may be configured to control overall operations of the CXL storage controller 311. The RAM 311c may be used as an operation memory or a buffer memory of the CXL storage controller 311.

The FTL 311d may perform various management operations for efficiently using the non-volatile memory NVM. For example, the FTL 311d may perform an address transformation between the logic block address managed by the host 301 and the physical block address used in the non-volatile memory NVM, based on the map data (or mapping table). The FTL 311d may perform a bad block management operation on the non-volatile memory NVM. The FTL 311d may perform a wear leveling operation on the non-volatile memory NVM. The FTL 311d may perform a garbage collection operation on the non-volatile memory NVM.

In an embodiment, the FTL 311d may be implemented based on software, hardware, firmware, or a combination thereof. When the FTL 311d is implemented in the form of the software or firmware, program codes related to the FTL 311d may be stored in the RAM 311c and may be driven by the processor 311b. When the FTL 311d is implemented as hardware, hardware elements formed to perform the above various management operations may be implemented in the CXL storage controller 311.

The ECC engine 311e may perform an error detection and correction on the data stored in the non-volatile memory NVM. For example, the ECC engine 311e may generate a parity bit with respect to user data UD to be stored in the non-volatile memory NVM, and the generated parity bits may be stored in the non-volatile memory NVM along with the user data UD. When the user data UD is read from the non-volatile memory NVM, the ECC engine 311e may detect and correct an error in the user data UD by using the parity bits read from the non-volatile memory NVM along with the user data UD.

The NAND interface circuit 311f may control the non-volatile memory NVM so that the data may be stored in or read from the non-volatile memory NVM. In an embodiment, the NAND interface circuit 311f may be implemented to comply with standard rules such as Toggle interface or ONFI. For example, the non-volatile memory NVM may include a plurality of NAND flash devices, and when the NAND interface circuit 311f is implemented based on a Toggle interface, the NAND interface circuit 311f may communicate with the plurality of flash devices via a plurality of channels. The plurality of NAND flash devices may be connected to a plurality of channels via a multi-channel/multi-way structure.

The non-volatile memory NVM may store or output the user data UD according to the control from the CXL storage controller 311. The non-volatile memory NVM may store or output map data MD according to the control from the CXL storage controller 311. In an embodiment, the map data MD stored in the non-volatile memory NVM may include mapping information corresponding to the entire user data UD stored in the non-volatile memory NVM. The map data MD stored in the non-volatile memory NVM may be stored in the CXL memory 320 during an initializing operation of the CXL storage 310.

The CXL memory 320 may include the CXL memory controller 321 and the buffer memory BFM. The CXL memory controller 321 may include a CXL memory interface circuit 321a, a processor 321b, a memory manager 321c, and a buffer memory interface circuit 321d.

The CXL memory interface circuit 321a may be connected to the CXL switch SW_CXL. The CXL memory interface circuit 321a may communicate with the host 301 or the CXL storage 310 via the CXL switch SW_CXL.

The processor 321b may be configured to control overall operations of the CXL memory controller 321. The memory manager 321c may be configured to manage the buffer memory BFM. For example, the memory manager 321c may be configured to convert the memory address (e.g., logic address or virtual address) accessed by the host 301 or the CXL storage 310 into the physical address about the buffer memory BFM. In an embodiment, the memory address may be an address for managing the storage area of the CXL memory 320, and may be a logic address or virtual address designated and managed by the host 301.

The buffer memory interface circuit 321d may control the buffer memory BFM so that the data may be stored in or read from the buffer memory BFM. In an embodiment, the buffer memory interface circuit 322d may be implemented to comply with standard rules such as DDR interface, LPDDR interface, etc.

The buffer memory BFM may store the data or output the stored data according to the control from the CXL memory controller 321. In an embodiment, the buffer memory BFM may be implemented to store the map data MD used in the CXL storage 310. The map data MD may be transferred from the CXL storage 310 to the CXL memory 320 during the initializing operation of the computing system 300 or the CXL storage 310.

As described above, the CXL storage 310 may store the map data MD that is used to manage the non-volatile memory NVM, in the CXL memory 320 connected thereto via the CXL switch SW_CXL (or CXL interface IF_CXL). After that, when the CXL storage 310 performs a reading operation according to the request from the host 301, the CXL storage 310 may read at least some of the map data MD from the CXL memory 320 via the CXL switch SW_CXL (or CXL interface IF_CXL) and may perform the reading operation based on the read map data MD. In some embodiments, when the CXL storage 310 performs a writing operation according to a request from the host 301, the CXL storage 310 may perform the writing operation on the non-volatile memory NVM and update the map data MD. Here, the updated map data MD may be primarily stored in the RAM 311c of the CXL storage controller 311, and the map data MD stored in the RAM 311c may be transferred to the buffer memory BFM of the CXL memory 320 via the CXL switch SW_CXL (or CXL interface IF_CXL) and updated.

In an embodiment, at least some of the regions in the buffer memory BFM of the CXL memory 320 may be allocated as a dedicated area for the CXL storage 310, and the remaining region may be used as a region accessible by the host 301.

In an embodiment, the host 301 and the CXL storage 310 may communicate with each other via CXL.io that is an input/output protocol. CXL.io may have a non-consistent input/output protocol based on peripheral component interconnect express (PCIe). The host 301 and the CXL storage 310 may exchange user data or various information with each other by using CXL.io. CXL.io is an input/output protocol of the CXL standard.

In an embodiment, the CXL storage 310 and the CXL memory 320 may communicate with each other via CXL.mem that is a memory access protocol. CXL.mem may be a memory access protocol supporting memory access. The CXL storage 310 may access some region of the CXL memory 320 (e.g., region in which the map data MD is stored or dedicated area for the CXL storage) by using CXL.mem. CXL.mem is a memory access protocol of the CXL standard.

In an embodiment, the host 301 and the CXL memory 320 may communicate with each other by using CXL.mem that is a memory access protocol. The host 301 may access the remaining region of the CXL memory 320 (e.g., a region other than the region where the map data MD is stored or a region other than the dedicated area for the CXL storage) by using CXL.mem.

The above-described access types (CXL.io, CXL.mem, etc.) are examples and embodiments are not limited to the above examples.

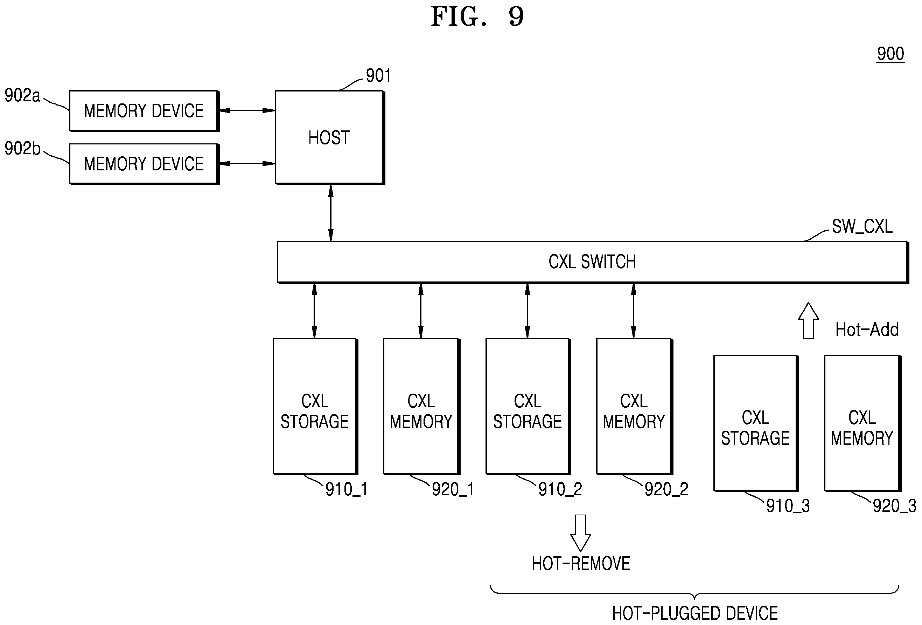

In an embodiment, the CXL storage 310 and the CXL memory 320 may be mounted in a physical port (e.g., PCIe physical port) based on the CXL interface. In an embodiment, the CXL storage 310 and the CXL memory 320 may be implemented based on E1.S, E1.L, E3.S, E3.L, and/or PCIe AIC(CEM) form factors. In some embodiments, the CXL storage 310 and the CXL memory 320 may be implemented based on U.2 form factor, M.2 form factor, and/or other various types of PCIe-based form factors, and/or other various types of small form factors. The CXL storage 310 and the CXL memory 320 may support a hot-plug function to be attachable to/detachable from a physical port. The hot-plug function is described in detail below with reference to FIG. 9.

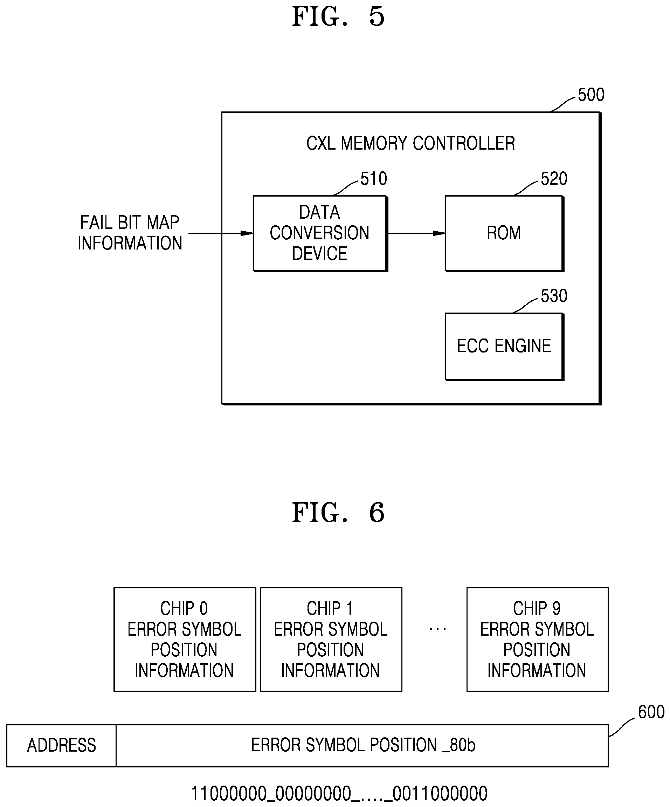

FIG. 5 is a diagram showing an example of a CXL memory controller 500 according to an embodiment, and FIG. 6 is a diagram showing an example of ECC predecoded information stored in a ROM 520 of the CXL memory controller 500.

Referring to FIG. 5, the CXL memory controller 500 may include a data conversion device 510, the ROM 520, and an ECC engine 530. In an embodiment, the CXL memory controller 500 of FIG. 5 may correspond to the CXL memory controller 321 of FIGS. 3 and 4.

According to an embodiment, the data conversion device 510 may receive a fail bit map. In some embodiments, the fail bit map may be received from a server (not shown). In some embodiments, the fail bit map may be received by the data conversion device 510 implemented in the CXL memory controller 500, the fail bit map may denote bit map information with respect to the chips included in the CXL memory (e.g., buffer memory BFM of FIGS. 3 and 4), rather than the fail bit map with respect to the total chips on the wafer (as discussed earlier).

The data conversion device 510 may convert the fail bit map into ECC predecoded information and store the ECC predecoded information in the ROM 520. The data conversion device 510 may convert the fail bit map in an ECC processing unit or a symbol unit. Here, the information as to an error symbol position may be a set of bits. In an embodiment, the bits may be predefined. For example, each of the bits may indicate which symbol of a certain address has an error.

According to an embodiment, the data conversion device 510 may convert at least some of a plurality of error symbols into ECC predecoded information, based on the fail bit map. For example, when the data conversion device 510 converts all symbols including an error in at least one bit into ECC predecoded information and stores the ECC predecoded information in the ROM 520 based on the fail bit map, the capacity of the ROM 520 may be insufficient. Therefore, the data conversion device 510 may convert the ECC predecoded information based on the threshold number. For instance, the data conversion device 510 may convert only symbols in which a number of bits having an error is greater than or equal to the threshold number into the ECC predecoded information. For example, in an embodiment, the threshold number may be 2. In this case, the data conversion device 510 may convert only the symbol in which the error occurs in at least two bits into the ECC predecoded information, based on the fail bit map.

According to an embodiment, the data conversion device 510 may generate and store ECC predecoded information 600 matching to the CXL memory (e.g., the buffer memory BFM of FIGS. 3 and 4). For example, referring to FIGS. 5 and 6 together, the data conversion device 510 may map error symbol position information to each of chips (e.g., 10 chips forming one rank) forming the CXL memory with respect to a certain address. In an embodiment, each of the chips forming the CXL memory may be a DDR5 x4 chip. The DDR5 x4 chip may include four DQ pins for outputting data. Output from each of the DQ pins includes 16 bits of a bit line, and thus, one DDR5 x4 chip may output 64 bits. As described above, because one symbol has 8 bits, the output of 64 bits may correspond to eight symbols. Therefore, each of the DDR5 x4 chips may map 8 symbols to 8 bits (e.g. one bit per symbol) to indicate which symbol has an error. For example, ECC predecoded information 600 may combine error symbol position information of each of a first chip (Chip 0) to a tenth chip (Chip 9) corresponding to a certain address. It may be identified which symbol in a chip has an error by using 8 bits for each chip with respect to the certain address, and the magnitude (e.g. size) of the error symbol position information with respect to a certain address of the CXL memory may be 80 bits. However, the number of chips forming the CXL memory, the size of the error symbol position information, etc. are not limited thereto and may vary according to an ECC unit, a symbol size, a size of the code word, etc.

The ECC engine 530 may perform the ECC decoding based on the ECC predecoded information stored in the ROM 520. For example, the ECC engine 530 may perform the decoding based on the Reed-Solomon code. According to the embodiment, the ECC engine 530 may detect an error during runtime. For example, an error may occur in an address other than the address stored in the ROM 520, due to retention degradation over time in the DRAM. The ECC engine 530 may determine whether the address in which the error occurs corresponds to the address in the ECC predecoded information. When the address in which the error occurs does not correspond to the plurality of addresses in the ECC predecoded information, the ECC engine 530 may update the ROM 520. Here, the ECC engine 530 may add the new address so as to match to the format of the ECC predecoded information in the ROM 520.

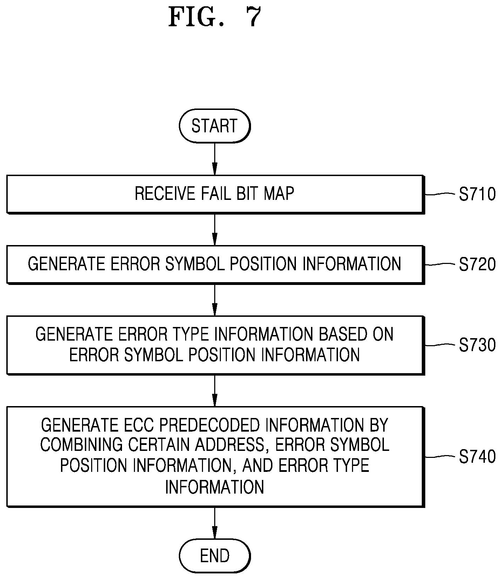

FIG. 7 is a flowchart illustrating an operating method of a data conversion device according to an embodiment.

Referring to FIG. 7, in operation S710, the data conversion device (e.g., the data conversion device 200 of FIG. 2A and/or the data conversion device 510 of FIG. 5) may receive the fail bit map. The fail bit map may include information of error bits with respect to the plurality of chips on the wafer. The fail bit map may be in a single bit unit, may be in an 8-bit unit for repairing, or may be in an address unit, a column unit, or a row unit.

In operation S720, the data conversion device may generate error symbol position information. For example, the data conversion device may generate the error symbol position information by identifying which symbol from among the symbols with respect to the certain address corresponds to the position where the error has occurred and generating the error symbol position information based on the identified symbols. For example, a first chip from among the plurality of chips may have an error at a first address. The data conversion device may identify a plurality of symbols corresponding to the first address. For example, every 8 bits may configure one symbol. The data conversion device may identify which symbol has an error in an ECC unit or a symbol unit. In the Reed-Solomon code decoding, which symbol has an error (e.g., error location) is identified and which bit from among the bits forming the symbol in which the error has occurred is an error bit (e.g., error magnitude) is identified. Based on the error symbol position information, the additional error may be corrected through a decoding method (e.g., erasure decoding) which corrects the additional error symbol. It is advantageous to identify which symbol has the bits one of which has an error occurred therein, and even without information on which bit in the corresponding symbol has an error, the error correction performance may be improved. For example, when it is identified which symbol has the error (e.g., error location), the corresponding symbol having the error may be referred to as an erasure symbol, and when it is not identified which symbol has the error, the symbol is referred to as an error symbol. Storing of the fail bit map corresponds to a marking of an erasure. In the case of a Reed-Solomon code having a correction capacity of 2, up to two error symbols may be corrected, and in the case of an erasure symbol, up to four symbols may be corrected. In some embodiments, when there are two erasure symbols, one error symbol may be corrected. Therefore, the error may be additionally corrected through the error symbol position information, and the error correction performance may be improved.

The data conversion device may identify which one of a plurality of symbols corresponding to the first address (e.g., 8 symbols corresponding to the first address) has an error, based on information on the first chip in the fail bit map, and may generate error symbol position information. The error symbol position information may include 8 bits, each of which may indicate whether the error has occurred in the symbol in the corresponding order. That is, the number of bits may be equal to the number of symbols corresponding to the first address. For example, it may be assumed that the error symbol position information is "10101010". In this case, the error symbol position information may indicate that the error occurs in the first, third, fifth, and seventh symbols in 8 symbols corresponding to the first address. In another example, it may be assumed that the error symbol position information is "10000000". In this case, the error symbol position information may indicate that the error occurs in the first symbol in 8 symbols corresponding to the first address. Accordingly, each bit may indicate whether an error occurs in a corresponding symbol of the plurality of symbols corresponding to the first address.

In operation S730, the data conversion device may generate error type information based on the error symbol position information. For example, in the case of the above error symbol position information of "10000000", the data conversion device may generate error type information of "01" indicating that the error occurs in only one of the symbols of the first address. In another example, it may be assumed that the error symbol position information is "11000000". In this case, the error symbol position information may indicate that the error occurs in the first and second symbols in 8 symbols corresponding to the first address. When the first and second symbols of the first address have the same row address, the data conversion device may generate error type information of "10" indicating a row defect. In the above error symbol position information of "10101010", when the first, third, fifth, and seventh symbols from among 8 symbols corresponding to the first address have the same column address, error type information of "11" indicating the column defect may be generated.

In operation S740, the ECC predecoded information may be generated by combining a certain address, error symbol position, and error type information. For example, the data conversion device may generate the ECC predecoded information by combining the first address, the error symbol position information for indicating at least one symbol having the error from among the symbols corresponding to the first address, and the error type information for indicating the type of the at least one symbol in which the error has occurred. According to some embodiments, the data conversion device may generate ECC predecoded information on a plurality of chips included in the CXL memory. For example, the data conversion device may combine the error symbol position information indicating the error symbol from among the symbols corresponding to the first address in each of the plurality of chips.

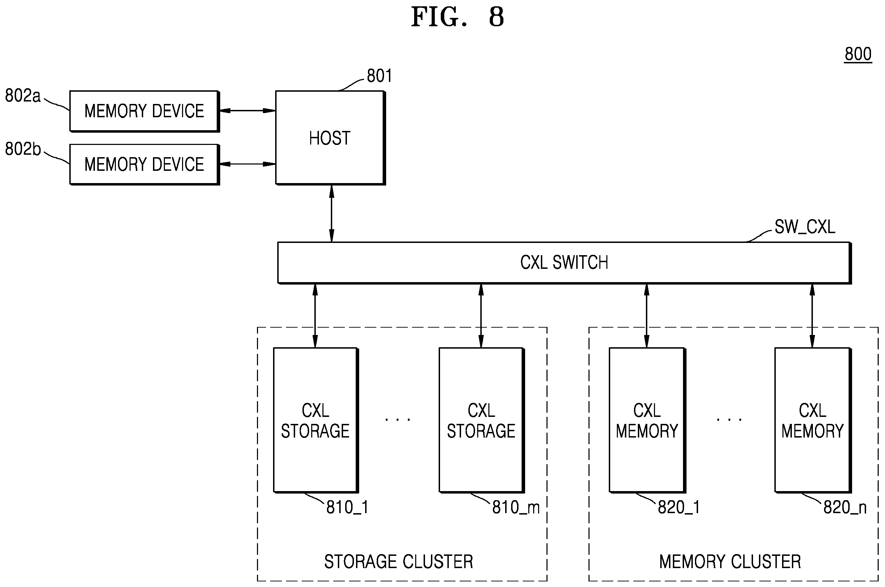

FIG. 8 is a block diagram of a computing system 800 according to an embodiment. Hereinafter, detailed descriptions about the elements provided in the above embodiments are omitted for convenience of description and for conciseness.

Referring to FIG. 8, the computing system 800 may include a host 801, a plurality of memory devices 802a and 802b, a CXL switch SW_CXL, a plurality of CXL storages 810_1 to 810_m, and a plurality of CXL memories 820_1 to 820_n.

The host 801 may be directly connected to the plurality of memory devices 802a and 802b. The host 801, the plurality of CXL storages 810_1 to 810_m, and the plurality of CXL memories 820_1 to 820_n may be connected to the CXL switch SW_CXL, and may communicate with one another via the CXL switch SW_CXL.

In an embodiment, the host 801 may manage the plurality of CXL storages 810_1 to 810_m as one storage cluster and manage the plurality of CXL memories 820_1 to 820_n as one memory cluster. The host 801 may allocate some region of the memory cluster to one storage cluster as a dedicated area (that is, an area for storing map data of the storage cluster). In some embodiments, the host 801 may allocate regions in the plurality of CXL memories 820_1 to 820_n to the plurality of CXL storages 810_1 to 810_m as dedicated areas, respectively.

FIG. 9 is a block diagram of a computing system 900 according to an embodiment. Hereinafter, detailed descriptions about the elements provided in the above embodiments are omitted for convenience of description and for conciseness.

Referring to FIG. 9, the computing system 900 may include a host 901, a plurality of memory devices 902a and 902b, a CXL switch SW_CXL, a plurality of CXL storages 910_1, 910_2, and 910_3, and a plurality of CXL memories 920_1, 920_2, and 920_3.

The host 901 may be directly connected to the plurality of memory devices 902a and 902b. The host 901, the plurality of CXL storages 910_1 and 910_2, and the plurality of CXL memories 920_1 and 920_2 may be connected to the CXL switch SW_CXL, and may communicate with one another via the CXL switch SW_CXL. Similarly to the above description, some regions of the CXL memories 920_1 and 920_2 may be allocated as dedicated areas for the CXL storages 910_1 and 910_2.

In an embodiment, during the driving of the computing system 900, the CXL storages 910_1 and 910_2 or the CXL memories 920_1 and 920_2 may be partially released from the connection to the CXL switch SW_CXL or removed from the CXL switch SW_CXL (hot-remove). In some embodiments, during the driving of the computing system 900, the CXL storage 910_3 or the CXL memory 920_n may be connected to or added to the CXL switch SW_CXL (hot-add). In this case, the host 901 may re-perform the memory allocation by performing initializing operations on the devices connected to the CXL switch SW_CXL via a reset operation or hot-plug operation. That is, the CXL storage and the CXL memory may support the hot-plug function, and through various connections, a storage capacity and memory capacity of the computing system may be expanded.

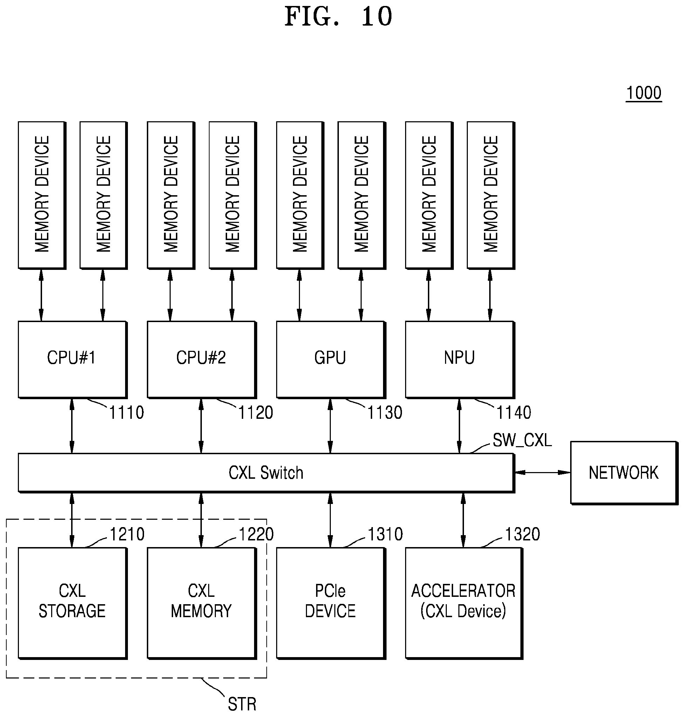

FIG. 10 is a block diagram of a computing system 1000 according to an embodiment. Hereinafter, detailed descriptions about the elements provided in the above embodiments are omitted for convenience of description and for conciseness.

Referring to FIG. 10, the computing system 1000 may include a first CPU 1110, a second CPU 1120, a GPU 1130, an NPU 1140, a CXL switch SW_CXL, a CXL storage 1210, a CXL memory 1220, a PCIe device 1310, and an accelerator (CXL device) 1320.

The first CPU 1110, the second CPU 1120, the GPU 1130, the NPU 1140, the CXL storage 1210, the CXL memory 1220, the PCIe device 1310, and the accelerator (CXL device) 1320 may be commonly connected to the CXL switch SW_CXL, and may communicate with one another via the CXL switch SW_CXL.

In an embodiment, each of the first CPU 1110, the second CPU 1120, the GPU 1130, and the NPU 1140 may be the host described above with reference to FIGS. 1 to 9, and may be directly connected to an individual memory device.

In an embodiment, the CXL storage 1210 and the CXL memory 1220 may correspond respectively to the CXL storage and the CXL memory described above with reference to FIGS. 1 to 8, and at least partial region of the CXL memory 1220 may be allocated as a dedicated area for the CXL storage 1210 by one or more of the first CPU 1110, the second CPU 1120, the GPU 1130, and the NPU 1140. That is, the CXL storage 1210 and the CXL memory 1220 may be used as storage spaces STR of the computing system 1000.

In an embodiment, the CXL switch SW_CXL may be connected to the PCIe device 1310 or the accelerator (CXL device) 1320 that are configured to support various functions, and the PCIe device 1310 or the accelerator 1320 may communicate with each of the first CPU 1110, the second CPU 1120, the GPU 1130, and the NPU 1140 or may access a storage space STR including the CXL storage 1210 and the CX memory 1220 via the CXL switch SW_CXL.

In an embodiment, the CXL switch SW_CXL may be connected to an external network or fabric and may communicate with an external server via the external network or fabric.

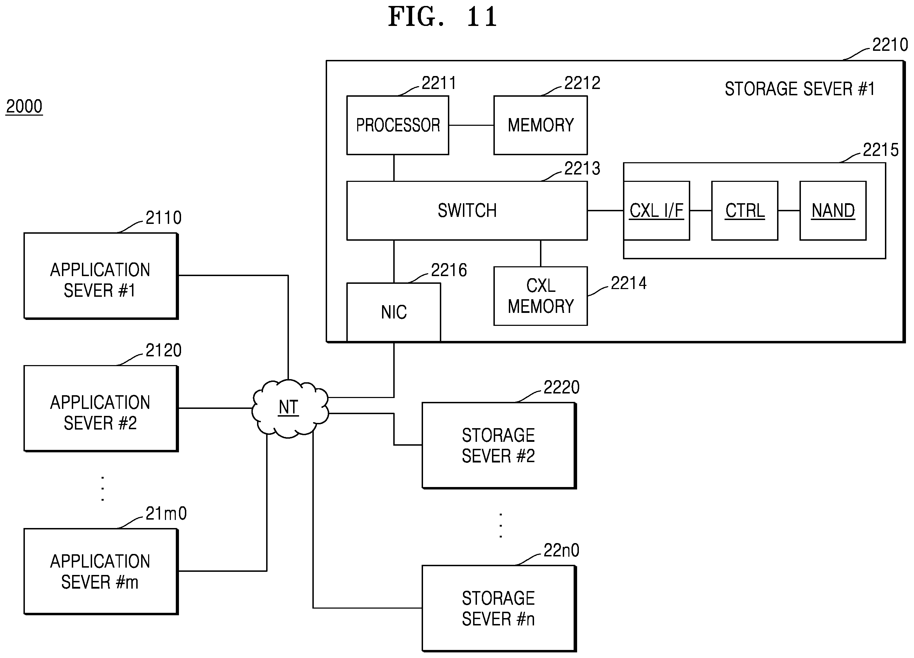

FIG. 11 is a block diagram of a data center 2000 according to an embodiment. The data center 2000 may include a computing system according to an embodiment. Hereinafter, detailed descriptions about the elements provided in the above embodiments are omitted for convenience of description and for conciseness.

Referring to FIG. 11, the data center 2000 is facility that collects various data and provides services and may be referred to as a data storage center. The data center 2000 may be a system for operating a search engine and a database, and may be a computing system used in companies such as banks, or government organizations. The data center 2000 may include a plurality of application servers including a first application server 2110 to an m-th application server 21m0. The data center 2000 may include a plurality of storage servers including a first storage server 2210 to an n-th storage server 22n0. The number of application servers and the number of storage servers may be variously selected according to embodiments, and in an embodiment, the number of the application servers may differ from the number of the storage servers.

Hereinafter, a structure of the first storage server 2210 is mainly described below. Each of the application servers 2110 to 21m0 and each of the storage servers 2210 to 22n0 may have similar structures to one another, and the application servers 2110 to 21m0 and the storage servers 2210 to 22n0 may communicate with one another via a network NT.

The first storage server 2210 may include a processor 2211, a memory 2212, a switch 2213, a storage device 2215, a CXL memory 2214, and a network interface card (NIC) 2216. The processor 2211 may control overall operations of the first storage server 2210 and may access the memory 2212 to execute instructions loaded on the memory 2212 or process data. Examples of the memory 2212 may include Double Data Rate Synchronous DRAM (DDR SDRAM), High Bandwidth Memory (HBM), Hybrid Memory Cube (HMC), DIMM, Optane DIMM, and/or Non-Volatile DIMM (NVMDIMM). The processor 2211 and the memory 2212 may be directly connected to each other, and the number of processors 2211 and the number of the memories 2212 included in one storage server 2210 may be variously selected.

In an embodiment, the processor 2211 and the memory 2212 may provide a processor-memory pair. In an embodiment, the number of processors 2211 may differ from the number of memories 2212. The processor 2211 may include a single-core processor or a multi-core processor. The above descriptions about the storage server 2210 may be similarly applied to each of the application servers 2110 to 21m0.

The switch 2213 may be configured to relay or route communications among various elements included in the first storage server 2210. In an embodiment, the switch 2213 may include the CXL switch SW_CXL described above with reference to FIGS. 1 to 10. That is, the switch 2213 may be implemented based on the CXL protocol.

The CXL memory 2214 may be connected to the switch 2213. In an embodiment, the CXL memory 2214 may be used as a memory expander for the processor 2211. In some embodiments, the CXL memory 2214 may be allocated as an exclusive memory or a buffer memory for the storage device 2215 as described above with reference to FIGS. 1 to 10.

The storage device 2215 may include a CXL interface circuit CXL_IF, a controller CTRL, and a NAND flash NAND. The storage device 2215 may store data or output stored data according to a request from the processor 2211. In an embodiment, the storage device 2215 may include the CXL storage described above with reference to FIGS. 1 to 10. In an embodiment, the storage device 2215 may be allocated with at least partial region of the CXL memory 2214 as a dedicated area, similar to the description provided with reference to FIGS. 1 to 10, and may use the dedicated area as a buffer memory (that is, the map data is stored in the CXL memory 2214).

According to an embodiment, the application servers 2210 to 21m0 may omit the storage device 2215. In some embodiments, the storage server 2210 may include at least one storage device 2215. The number of storage devices 2215 included in the storage server 2210 may be variously selected according to the embodiment.

The NIC 2216 may be connected to the CXL switch SW_CXL. The NIC 2216 may communicate with other storage servers 2220 to 22n0 or other application servers 2110 to 21m0 via the network NT.

In an embodiment, the NIC 2216 may include a network interface card, a network adaptor, etc. The NIC 2216 may be connected to the network NT via a wired interface, a wireless interface, a Bluetooth interface, an optical interface, etc. The NIC 2216 may include an internal memory, a digital signal processor (DSP), a host bus interface, etc., and may be connected to the processor 2211 and/or the switch 2213 via the host bus interface. In an embodiment, the NIC 2216 may be integrated with at least one of the processor 2211, the switch 2213, and the storage device 2215.

In an embodiment, the network NT may be implemented by using Fibre channel (FC), Ethernet, etc. Here, the FC is a medium used to transfer data at a relatively high speed, and may use an optical switch providing high performance/high availability. According to the accessing type of the network NT, the storage servers may be each provided as a file storage, a block storage, or an object storage.

In an embodiment, the network NT may include a storage-exclusive network such as a storage area network (SAN). For example, the SAN may include an FC-SAN that may use the FC network and may be implemented according to FC protocol (FCP). Otherwise, the SAN may include an IP-SAN that may use transmission control protocol/Internet protocol (TCP/IP) network and may be implemented according to a small computer system interface (SCSI) over TCP/IP or Internet SCSI (iSCSI) protocol. In an embodiment, the network NT may include a general network such as a TCP/IP network. For example, the network NT may be implemented according to a protocol such as FC over Ethernet (FCoE), network attached storage (NAS), non-volatile memory express (NVMe) over fabrics (NVMe-oF), etc.

In an embodiment, at least one of the application servers 2110 to 21m0 may store data that is requested to be stored from a user or a client in one of the storage servers 2210 to 22n0 via the network NT. At least one of the application servers 2110 to 21m0 may obtain the data that is requested to be read from the user or the client from one of the storage servers 2210 to 22n0 via the network NT. For example, at least one of the application servers 2110 to 21m0 may be implemented as a web server, a database management system (DBMS), etc.

In an embodiment, at least one of the application servers 2110 to 21m0 may access the memory, CXL memory, or the storage device included in another application server via the network NT, or may access the memories, CXL memories, or storage devices included in the storage servers 2210 to 22n0 via the network NT. As such, at least one of the application servers 2110 to 21m0 may perform various operations on the data stored in other application servers and/or storage servers. For example, at least one of the application servers 2110 to 21m0 may execute an instruction for moving or copying data between different application servers and/or the storage servers. Here, the data may be moved from the storage devices of the storage servers to the memories or CXL memories of the application servers directly or through the memories or the CXL memories of the storage servers. The data moved through the network may be encrypted for security or privacy.

In an embodiment, the storage device included in at least one of the application servers 2110 to 21m0 and the storage servers 2210 to 22n0 may receive allocation of the CXL memory included in at least one of the application servers 2110 to 21m0 and the storage servers 2210 to 22n0 as a dedicated area, and the storage device may use the dedicated area as a buffer memory (that is, storing map data). For example, the storage device 2215 included in the storage server 2210 may receive the allocation of the CXL memory included in another storage server (e.g., 22m0), and may access the CXL memory included another storage server (e.g., 22m0) via the switch 2213 and the NIC 2216. In this case, the map data with respect to the storage device 2215 of the first storage server 2210 may be stored in the CXL memory of another storage server 22m0. That is, the storage devices and the CXL memories of the data center according to the inventive concept may be connected and implemented in various ways.

While various embodiments have been particularly shown and described with reference to the drawings, it will be understood that various changes in form and details may be made therein without departing from the scope of the following claims.

## Claims

1. A compute expression link, CXL, memory controller comprising:
a data conversion device (510) that is configured to receive a fail bit map and convert the fail bit map into error correction code, ECC, predecoded information in a symbol unit;
a read only memory, ROM, (520) that is configured to store the ECC predecoded information; and
an ECC engine (530) that is configured to perform a decoding operation based on the ECC predecoded information,
wherein the ECC predecoded information includes address information indicating an address in which an error occurs, error symbol position information indicating at least one symbol in which the error occurs from among a plurality of symbols corresponding to the address, and error type information indicating an error type of the at least one symbol.

2. The CXL memory controller of claim 1, wherein the fail bit map includes error information of each of a first chip and a second chip included in a CXL memory connected to the CXL memory controller, and
the error symbol position information includes first error symbol position information indicating at least one symbol of the first chip in which an error occurs at a first address of the first chip, and second error symbol position information indicating at least one symbol of the second chip in which an error occurs at a second address of the second chip.

3. The CXL memory controller of claim 1 or claim 2, wherein the ECC engine is configured to perform the decoding operation based on a Reed-Solomon code.

4. The CXL memory controller of any preceding claim, wherein the error symbol position information includes bits, and a number of the bits is the same as a number of the plurality of symbols, and
the data conversion device (510) is configured to change the bits to logic high in an order that is the same as an order of symbols, in which the error occurs, from among the plurality of symbols.

5. The CXL memory controller of any preceding claim, wherein the error type information includes information indicating one of a first error type indicating that the error occurs in only one symbol from among the plurality of symbols corresponding to the address, a second error type indicating that the error occurs in at least two symbols from among the plurality of symbols corresponding to the address and the at least two symbols have a same row address, and a third error type in which the error occurs in at least two symbols from among the plurality of symbols corresponding to the address and the at least two symbols have a same column address.

6. The CXL memory controller of any preceding claim, wherein the ECC engine (530) is configured to receive an access request and perform ECC decoding based on the ECC predecoded information when a target address of the access request corresponds to the address information.

7. The CXL memory controller of any preceding claim, wherein the data conversion device (510) is configured to:
identify symbols in which the error occurs from among the plurality of symbols corresponding to the address, and
generate the error symbol position information indicating symbols including error bits that exceed a threshold number from among the symbols that are identified.

8. An operating method of a compute express link, CXL, memory controller, the operating method comprising:
receiving (710) a fail bit map;
converting (S720, S730, S740) the fail bit map into error correction code, ECC, predecoded information in a symbol unit;
storing the ECC predecoded information in a read only memory, ROM, (520); and
performing a decoding operation based on the ECC predecoded information,
wherein the ECC predecoded information includes address information indicating an address in which an error occurs, error symbol position information indicating at least one symbol in which the error occurs from among a plurality of symbols corresponding to the address, and error type information indicating an error type of the at least one symbol.

9. The operating method of claim 8, wherein the fail bit map includes error information of each of a first chip and a second chip included in a CXL memory connected to the CXL memory controller.

10. The operating method of claim 8 or claim 9, wherein the error symbol position information includes first error symbol position information indicating at least one symbol of the first chip in which an error occurs at a first address of the first chip, and second error symbol position information indicating at least one symbol of the second chip in which an error occurs at a second address of the second chip.

11. The operating method of any of claims 8-10, wherein an ECC engine (530) performs the decoding operation based on a Reed-Solomon code.

12. The operating method of any of claims 8-11, wherein the error symbol position information includes bits, and a number of the bits is the same as a number of the plurality of symbols, and
the converting includes changing the bits to logic high in an order that is the same as an order of symbols in which the error occurs from among the plurality of symbols.

13. The operating method of any of claims 8-12, wherein the error type information includes information indicating one of a first error type indicating that the error occurs in only one symbol from among the plurality of symbols corresponding to the address, a second error type indicating that the error occurs in at least two symbols from among the plurality of symbols corresponding to the address and the at least two symbols have a same row address, and a third error type in which the error occurs in at least two symbols from among the plurality of symbols corresponding to the address and the at least two symbols have a same column address.

14. The operating method of any of claims 8-13, wherein performing the decoding operation comprises:
receiving, by an ECC engine (530), an access request; and
when a target address of the access request corresponds to the address information, performing ECC decoding based on the ECC predecoded information.

15. The operating method of any of claims 8-14, wherein the converting comprises:
identifying symbols in which the error occurs from among a plurality of symbols corresponding to the address; and
generating the error symbol position information indicating symbols including error bits that exceed a threshold number, from among the symbols that are identified.
